# EUROPEAN PATENT SPECIFICATION

(11) **EP 3 535 785 B1**
(45) Date of publication and mention of the grant of the patent: **31.03.2021**
(21) Application number: 17808190.7
(22) Date of filing: 27.10.2017
(51) Int. Cl.: H01L 35/32, H01L 35/34

(54) **THIN THERMOELECTRIC LAYER**
DÜNNE THERMOELEKTRISCHE SCHICHT
COUCHE THERMOÉLECTRIQUE MINCE

(30) Priority: 03.11.2016 PL 41934716
(43) Date of publication of application: 11.09.2019
(73) Proprietor: AIC Spólka Akcyjna, 81-577 Gdynia (PL)
(72) Inventor: SIEMIENCZUK, Tomasz, 80-351 Gdansk (PL)
(74) Representative: Pomianek, Grazyna
(86) International application number: PCT/PL2017/000110
(87) International publication number: WO 2018/084727

(56) References cited:
- EP-A1- 1 988 584
- JP-A- 2009 194 309
- US-A1- 2007 125 413

## Description

The invention concerns a thin thermoelectric layer used in installations in which heat exchange takes place, in particular central heating and/or domestic water installations.

The market today expects new technical solutions and devices able to serve a growing number of functions, while at the same time getting more and more universal. Moreover, the entire industry is taking intense effort to develop new methods of generating electric energy. The majority of the micro-generating devices currently available in the market are based on principle of conversion of some form of kinetic energy to electric energy. Known are solutions employing different kinds of reciprocating engines, Stirling engines, turbines, etc. The solutions are characterised by substantial limitations resulting from the high level of their complexity which entails high production cost, as well as by low reliability and high costs related to ensure the required maintenance.

Known are thermoelectric devices employing the Seebeck effect, which enable generation of electric energy. The devices contain thermoelectric technical means where the temperature difference between specific areas enables generation of electric energy.

The current state of the art in the area of thermoelectric coatings implies that no solution has been found yet which would provide instruction on how to apply thermoelectric composites in a comprehensive manner and use them in devices. There are, however, some scientific publications which discuss specific methods of manufacturing the semiconductor components only, intended for thermocouples.
It should also be mentioned here that attempts are made to lay layers of bismuth telluride under the thermal spray method. Because of its high imprecision, however, the method proves poorly effective, and the produced systems of poor performance. Because of the open structure of the semiconductor junctions of the 'p' and 'n' type, the systems cannot be used safely.
Currently, the market is saturated only as concerns prefabricated thermocouples. Their fairly substantial limitations stem from their absolute lack of formability and their standardized sizes.
Recently, however, a new application group has been developed for the electricity generating thermocouples: they are used to generate electricity in the so-called hiking power generators. The devices employ heat energy to enable charging small receivers. Because of the size of the target market, however, and the technical solutions used one can hardly speak about industrial scale here. The heretofore experimental attempts at using prefabricated thermocouple modules do not stand any true chance of commercialization because of their production and size-related limitations. Another factor which effectively hampers the development of this specific industry branch is the high unit cost of thermocouples.

Known from patent document CN 104538542 (A) is a method of producing a multilayer coating of thermoelectric materials used in the manufacturing of thermoelectric devices generating electric energy, where the method employs the method of physical gaseous phase deposition. Layers of thermoelectric materials are applied to the appropriately selected base under the are magnetron sputtering method, where each individual layer is more than 5 nm thick.

Document JP 2009194309 A discloses the thermoelectric module includes: lower electrodes each having a P-type thermoelectric element and an N-type thermoelectric element disposed therein; upper electrodes each connecting a P-type thermoelectric element of one of adjacent lower electrodes to an N-type thermoelectric element of the other lower electrode namely, connecting the different kinds of thermoelectric elements and to each other when the thermoelectric elements and of the adjacent lower electrodes connect to each other; and insulating layers electrically insulating the lower electrodes and upper electrodes from each other.

The purpose of the invention is to develop a thermoelectric generator in the form of a thin layer which, when applied to those elements of devices in which heat exchange occurs, will pertain to higher energy efficiency of those devices which will at the same time produce electric energy used to supply electronic accessories or external devices, or delivered back to the power grid. In addition, the purpose of the invention is to solve the problems discussed in the first paragraphs hereof by providing technical means which would overcome low efficiency of thermoelectric devices and reduce their production costs.

The purpose has been achieved by developing a thermoelectric coating.

A thermoelectric coating, the functioning of which is based on the Seebeck effect, having a thermoelectric layer with semiconductor elements 'p' and 'n', where the semiconductor elements of the thermoelectric layer are formed into semiconductor sub-layers 'p' and 'n' which do not contact each other, the thickness of which ranges from 1µm to 10 µm, where the sub-layers are interconnected in series with layered conducting elements fitted with connection ends to evacuate the generated electric energy, where the thermoelectric layer is insulated on conducting elements with layers of electrical insulator comprising inorganic oxides, and the total thickness of the coating is 50 µm or less, according to the invention is characterised in that a first layer is the homogenous and continuous in structure electrical insulator layer, on which there is a first layer of the conducting element with the thickness within the range from 1µm to 5µm, on which there are alternating semiconductor sub-layers 'p', 'n' of the thermoelectric layer where the width of each semiconductor sub-layer 'p', 'n' ranges from 0.1 mm to 2 mm, on which there is a second layer of the conducting element with the thickness within the range from 1µm to 5 µm, on which there is a second layer of the homogenous and continuous in structure electrical insulator layer, the said electrical insulator layers comprise MgO, the said conducting element layers are made of copper.

The invention enables additional production of electric energy obtained using the thermoelectric coating embedded in the devices. The solution according to the invention is advantageous in that it does not involve noise or vibration generation thanks e.g. to the absence of any movable elements. Moreover, it ensures generation of electricity based on temperature difference directly, while bypassing the conversion of kinetic energy, which will translate to high reliability while avoiding any increase in device maintenance costs.

The electric energy produced can find different applications, e.g. in:
- supplying power to electrical sub-assemblies of a complete device, such as control elements or pumping systems (improving energy efficiency)
- building autonomous units independent of external power supply
- delivering energy back to the local power network (reducing the household demand for electric energy)
- delivering energy back to the power grid (micro sources, prosumer, citizen energy)

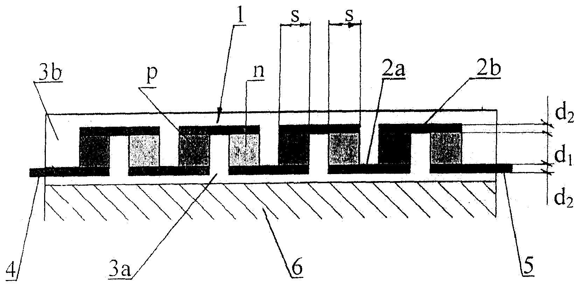

These and other characteristics of the invention will be clear from the following description of a preferential form of embodiment, given as a non-restrictive example, with reference to the attached drawing wherein the coating is shown in cross-section.

A thermoelectric coating, the functioning of which is based on the Seebeck effect, has a thermoelectric layer 1 with semiconductor elements 'p' and 'n', a series connection between the semiconductor elements 'p' and 'n' achieved using layered conducting elements 2a, 2b, and electrical insulator layers 3a, 3b. The coating layers are produced under the PVD technology e.g. by: evaporation, laser ablation, magnetron sputtering, filtered cathodic arc deposition, or electron beam PVD. The semiconductor elements 'p' and 'n' of the thermoelectric layer 1 take the form of semiconducting sublayers not contacting each other, formed into alternating rings 'p' and 'n', the thickness di of which ranges from 1 µm to 10 µm, preferably amounting to 5 µm, and the width of which falls within the range from 0.1 mm to 2mm, preferably amounting to 1mm, where the rings are interconnected in series with layered conducting elements 2a, 2b made of copper, the thickness d₂ of which ranges from 1 to 5 µm, preferably amounting to 3 µm, fitted with connection ends 4, 5 to evacuate the generated electric energy. The semiconductor layers of the 'p' and 'n' types can be made of the following material groups: lead telluride; tin selenide; telluride, antimony, and bismuth compounds; inorganic occlusion compounds; skutterudite; semi-Heusler compounds; silicon compounds; and germanium compounds. Each layer 3a, 3b of electrical insulator is produced based on inorganic oxides, comprising MgO. The total thickness of the coating is 50 µm or less.

First, the process of producing the electric insulator layer 3a should be performed in the technological chamber, thanks to which the thermoelectric layer 1 will be electrically independent of the base 6. The electrical insulator layer must be homogenous and continuous in structure. It will make it highly resistant to avalanche breakdown. Then, appropriately located layered conducting elements 2a should be made, which will form the basis and serve as electrical connection between the semiconductor sub-layers 'p' and 'n'. Copper seems a good choice because of the ease of deposition and good conductivity.
Thanks to the interconnection between two different semiconductor layers 'p' and 'n' achieved using conducting elements 2a, 2b it will be possible to achieve the flow of current whenever the coating is exposed to temperature difference. The material should be selected according to the criteria of e.g. expected performance, the ensuing thermoelectric efficiency (ZT), and the anticipated range of temperatures to which the coating will be exposed during operation. In the next step, the appropriately located semiconductor sub-layers 'p' and 'n' should be made. Then, appropriately located layered conducting elements 2b should be produced to close the electrical circuit of the thermoelectric layer 1. The last step consists in the producing of the second layer 3b of the electrical insulator.

In accordance with Seebeck's theory, a difference in temperature on two sides of the coating triggers orderly movement of charges in the semiconductor sub-layers 'p' and 'n' contained in the thermoelectric layer 1. Due to the series connection between the sub-layers, a difference of potential occurs between the outermost connection points, i.e. ends 4, 5. The thus-produced energy can be used to supply power to electronic accessories or external devices, or delivered back to the power grid.

## Claims

1. A thermoelectric coating, the functioning of which is based on the Seebeck effect, having a thermoelectric layer with semiconductor elements 'p' and 'n', where the semiconductor elements of the thermoelectric layer (1) are formed into semiconductor sub-layers 'p' and 'n' which do not contact each other, the thickness (d₁) of which ranges from 1 µm to 10 µm, where the sub-layers are interconnected in series with layered conducting elements (2a, 2b) fitted with connection ends (4, 5) to evacuate the generated electric energy, where the thermoelectric layer (1) is insulated on conducting elements (2a, 2b) with layers (3a, 3b) of electrical insulator comprising inorganic oxides, and the total thickness of the coating is 50 µm or less, **characterised in that** a first layer is the homogenous and continuous in structure electrical insulator layer (3a), on which there is a first layer of the conducting element (2a) with the thickness (d₂) within the range from 1µm to 5µm, on which there are alternating semiconductor sub-layers 'p', 'n' of the thermoelectric layer (1) where the width (s) of each semiconductor sub-layer 'p', 'n' ranges from 0.1 mm to 2 mm, on which there is a second layer of the conducting element (2b) with the thickness (d₂) within the range from 1 µm to 5 µm, on which there is a second layer of the homogenous and continuous in structure electrical insulator layer (3b), the said electrical insulator layers (3a, 3b) comprise MgO, the said conducting element layers (2a, 2b) are made of copper.

## Patentansprüche

1. Eine thermoelektrische Beschichtung, die nach dem Seebeck-Effekt funktioniert, mit einer thermoelektrischen Schicht mit Halbleiterelementen "p" und "n", wobei die Halbleiterelemente der thermoelektrischen Schicht (1) als Halbleiterunterschichten "p" und "n" mit Stärke (d₁) von 1 µm bis 10 µm ausgebildet sind, die keinen Kontakt miteinander haben, wobei die Unterschichten mit Hilfe von geschichteten Leitelementen (2a, 2b) mit Anschlüssen (4, 5), die zur Ableitung des generierten Stroms in einer Reihe miteinander angeschlossen sind, wobei die thermoelektrische Schicht (1) an den Leitelementen (2a, 2b) mit Schichten (3a, 3b) eines anorganische Oxide enthaltenden elektrischen Isolators isoliert ist, und die Gesamtdicke der thermoelektrischen Beschichtung 50 µm oder weniger beträgt, **dadurch gekennzeichnet, dass** die erste Schicht aus einer Schicht (3a) des elektrischen Isolators besteht und ein homogenes und durchgehendes Gefüge aufweist, auf der die erste Schicht eines Leitelements (2a) mit einer Stärke (d₂) von 1 µm bis 5 µm liegt, auf der sich abwechselnd Halbleiterunterschichten "p" und "n" der thermoelektrischen Schicht (1) befinden, wobei die Breite (s) jeder Halbleiterunterschicht "p", "n" zwischen 0,1 mm und 2 mm beträgt, auf der eine zweite Schicht des Leitelements (2b) mit einer Stärke (d₂) zwischen 1 µm und 5 µm liegt, auf der eine zweite Schicht (3b) eines elektrischen Isolators liegt, das ein homogenes und durchgehendes Gefüge aufweist, wobei die genannten Schichten (3a, 3b) des elektrischen Isolators MgO enthalten, die genannten Schichten des Leitelements (2a, 2b) aus Kupfer ausgeführt sind.

## Revendications

1. Revêtement thermoélectrique agissante selon l'effet Seebeck, ayant une couche thermoélectrique avec des éléments semi-conducteurs "p" et "n", les éléments semi-conducteurs de la couche thermoélectrique (1) étant formés comme des sous-couches semi-conductrices sans contact "p" et "n" avec une épaisseur (d₁) de 1 µm à 10 µm, où les sous-couches sont connectées les unes aux autres en série avec des éléments conducteurs en couches (2a, 2b) pourvus de bornes de connexion (4, 5) pour la sortie de l'électricité produite, la couche thermoélectrique (1) étant isolée sur les éléments conducteurs (2a, 2b) par des couches (3a, 3b) d'un isolant électrique contenant oxydes inorganiques, et l'épaisseur totale du revêtement thermoélectrique étant de 50 µm ou moins, **caractérisé en ce que** la première couche est une couche d'isolant électrique (3a), homogène et continue dans la structure, sur laquelle se trouve la première couche de l'élément conducteur (2a) d'épaisseur (d₂) de 1 µm à 5 µm, sur laquelle sont alternées des sous-couches semi-conductrices "p" et "n", de la couche thermoélectrique (1), la (les) largeur (s) de chaque sous-couche semiconductrice "p", "n" étant de 0,1 mm à 2 mm, sur laquelle se trouve une deuxième couche de l'élément conducteur (2b) d'épaisseur (d₂) comprise entre 1 µm à 5 µm, sur laquelle se trouve une deuxième couche (3b) d'un isolant électrique homogène et continu dans sa structure, lesdites couches (3a, 3b) de l'isolant électrique contiennant du MgO, lesdites couches de l'élément conducteur (2a, 2b) étant réalisées en cuivre.
